# EUROPÄISCHE PATENTSCHRIFT

(11) **EP 2 306 648 B1**
(45) Veröffentlichungstag und Bekanntmachung des Hinweises auf die Patenterteilung: **19.06.2013**
(21) Anmeldenummer: 09172101.9
(22) Anmeldetag: 02.10.2009
(51) Int. Cl.: H03K 17/965, G06F 3/023

(54) **Vollduplex Datenübertragung mittels eines tragbaren elektronischen Geräts und eines Feldgeräts**
Duplex data transfer via portable electronic device and field device
Transmission de données duplex par appareil électronique portatif et appareil de terrain

(43) Veröffentlichungstag der Anmeldung: 06.04.2011
(73) Patentinhaber: Siemens Aktiengesellschaft, 80333 München (DE)
(72) Erfinder: Weiler, Christoph Dr., 75015, Bretten (DE); Hammer, Gerhard, 76777, Neupotz (DE)

(56) Entgegenhaltungen:
- EP-A1- 0 788 627
- WO-A1-01/80444
- WO-A1-2004/025546
- WO-A2-2004/006350
- DE-A1- 10 005 486
- DE-A1- 10 344 575

## Beschreibung

Die Erfindung betrifft eine Vorrichtung zur Übertragung von Daten zwischen einem tragbaren elektronischen Gerät und einem Feldgerät nach dem Oberbegriff des Anspruchs 1 sowie ein tragbares elektronisches Gerät und ein Feldgerät nach Anspruch 7 bzw. Anspruch 8 für eine derartige Vorrichtung.

In prozesstechnischen Anlagen werden zur Steuerung von Prozessen vielfältige Feldgeräte für die Prozessinstrumentierung eingesetzt. Messumformer dienen zur Erfassung von Prozessvariablen, wie beispielsweise Temperatur, Druck, Durchflussmenge, Füllstand, Dichte oder Gaskonzentration eines Mediums. Durch Stellglieder kann der Prozessablauf in Abhängigkeit von erfassten Prozessvariablen entsprechend einer beispielsweise von einer Leitstation vorgegebenen Strategie beeinflusst werden. Als Beispiele für Stellglieder seien ein Regelventil, eine Heizung oder eine Pumpe genannt. Damit derartige Feldgeräte an ihrem Einsatzort in der gewünschten Weise arbeiten, muss üblicherweise eine Parametrierung vorgenommen werden, bei welcher beispielsweise bei einem Messumformer Anfangsund Endwert des Messbereichs festgelegt werden. Ist das Feldgerät selbst mit einer Eingabetastatur und einer Anzeige versehen, so kann die Parametrierung in einer Vor-Ort-Bedienung, beispielsweise mittels mechanischer Tasten oder Infrarot-Reflektionstasten, vorgenommen werden. Die Anzeige von Feldgeräten ist üblicherweise als flächenmäßig relativ kleines Graphikdisplay ausgeführt, auf welchem bei alphanumerischer Darstellung nur geringe Informationsmengen ausgegeben werden können. Da Feldgeräte oft an unzugänglichen Orten in einer prozesstechnischen Anlage eingebaut sind, ist die Ablesbarkeit in vielen Fällen zudem erschwert. Daher werden oft nur einfache, unbedingt notwendige Parametrierschritte vorgenommen. Zudem sind die Möglichkeiten, in einer Vor-Ort-Bedienung eine Diagnose des Feldgeräts durchzuführen, durch die einfachen Bedienelemente sehr stark eingeschränkt. Daher besteht häufig der Wunsch, dass mittels eines tragbaren elektronischen Geräts, das mit komfortableren Bedienelementen ausgestattet ist, zum Beispiel mittels eines Bedienpanels, eines Handheld-Geräts oder eines Notebooks, vor Ort auf die Daten des Feldgeräts zugegriffen werden kann und somit in einfacherer Weise komplexe Bedienschritte am Feldgerät möglich werden.

Aus der DE 103 44 575 A1 ist eine Vorrichtung zur Übertragung von Daten zwischen einem tragbaren elektronischen Gerät und einem Feldgerät bekannt, bei welcher am Feldgerät eine zusätzliche Schnittstelle vorgesehen ist, mittels der das Feldgerät mit dem elektronischen Gerät verbunden werden kann. Das Vorsehen einer derartigen zusätzlichen Schnittstelle ist in nachteiliger Weise mit einem erhöhten Herstellungsaufwand des Feldgeräts verbunden.

Aus der EP 0 788 627 B1 ist ein verteiltes Steuerungssystem mit Feldgeräten bekannt, die an ein drahtgebundenes Netzwerk angeschlossen sind. Damit eine Parametrierung der Feldgeräte nicht umständlich über das Netzwerk vorgenommen werden muss, verfügen die Feldgeräte zusätzlich über eine drahtlose Schnittstelle, durch welche eine drahtlose Verbindung zwischen dem Feldgerät und einem tragbaren elektronischen Gerät eines Bedieners herstellbar ist. Die drahtlose Verbindung kann beispielsweise durch eine Funk-, Licht-, oder Schallübertragungsstrecke realisiert sein. Die zum Betrieb des Feldgeräts erforderliche Energie wird über den drahtgebundenen Netzwerkanschluss zugeführt. Auch diese zusätzliche, drahtlose Schnittstelle verursacht in nachteiliger Weise einen höheren Aufwand bei der Herstellung von Feldgeräten. Hinzu kommen Sicherheitsbedenken bei einigen Anwendern und generelle Vorbehalte, die beispielsweise gegen die Verwendung einer Funkkommunikation in prozesstechnischen Anlagen sprechen.

Aus der DE 100 05 486 A1 ist eine Vorrichtung zur Übertragung von Daten von einem ersten Gerät mit einer Displayeinrichtung zu einem zweiten Gerät bekannt. Dabei wird vom ersten Gerät mittels der Displayeinrichtung aus den zu übermittelnden Daten ein maschinenlesbarer Code erzeugt und dieser Code wird von einer Leseeinrichtung des zweiten Geräts maschinell gelesen.

Der Erfindung liegt die Aufgabe zugrunde, eine Vorrichtung zur Übertragung von Daten zwischen einem tragbaren elektronischen Gerät und einem Feldgerät zu schaffen, die eine bidirektionale Übertragung ermöglicht und zu deren Realisierung keine konstruktive Änderung an einem bestehenden Feldgerät vorgenommen werden muss. Weitere Aufgaben sind, ein tragbares elektronisches Gerät und ein Feldgerät für eine derartige Vorrichtung zu schaffen.

Zur Lösung dieser Aufgabe weist die neue Vorrichtung der eingangs genannten Art die im kennzeichnenden Teil des Anspruchs 1 angegebenen Merkmale auf. Vorteilhafte Weiterbildungen sind in den abhängigen Ansprüchen beschrieben. In Anspruch 7 ist ein tragbares elektronisches Gerät, in Anspruch 8 ein Feldgerät für eine derartige Vorrichtung zur Übertragung von Daten angegeben.

Die Erfindung hat den Vorteil, dass die Bedienung eines Feldgeräts mit einem tragbaren Bediengerät vor Ort, das heißt beispielsweise nicht von einer entfernten Leitwarte aus, ermöglicht wird, ohne dass hierzu eine zusätzliche Schnittstelle am Feldgerät vorgesehen werden muss. Weiterhin ist kein zusätzlicher Aufwand, wie beispielsweise das Öffnen eines Gehäuses des Feldgeräts oder das Anklemmen von Anschlussleitungen an vorhandene Kommunikationsleitungen, über welche das Feldgerät seine Messwerte an eine übergeordnete Station überträgt, erforderlich. An einem bestehenden Feldgerät, das über eine Anzeige und eine Eingabetastatur verfügt, sind in vorteilhafter Weise keinerlei Hardware-Änderungen erforderlich, um es für einen Einsatz in der neuen Vorrichtung zur Übertragung von Daten zu ertüchtigen. Am Feldgerät genügt bereits das Nachladen von Programmmodulen, welche derart ausgestaltet sind, dass maschinenlesbare Codes auf der Anzeige des Feldgeräts ausgebbar sind, welche den zum elektronischen Gerät hin zu übertragenden Daten entsprechen, und dass über die Eingabetastatur des Feldgeräts maschinell eingegebene Codes, welche die zum Feldgerät hin zu übertragenden Daten darstellen, durch das Feldgerät auswertbar sind. Gegenüber einer direkten Bedienung des Feldgeräts über die vorhandene Anzeige und Eingabetastatur hat die Bedienung mit Hilfe eines tragbaren elektronischen Geräts, welches zur Datenübertragung mit dem Feldgerät verbunden ist, den Vorteil, dass eine bessere und umfangreichere Darstellung von Feldgerätedaten und eine komfortablere Eingabe von Feldgeräteparametern ermöglicht werden. Dieser Vorteil wiegt in den Fällen umso schwerer, in welchen das Feldgerät aufgrund seines Einbauplatzes in einer prozesstechnischen Anlage zur direkten Bedienung kaum zugänglich ist. Durch das vom Feldgerät abgesetzte, tragbare elektronische Gerät sind Feldgeräte auch in solchen Situationen gut bedienbar.

Erfindungsgemäß werden somit Schnittstellen, die eigentlich für die Bedienung des Feldgeräts durch den Menschen konzipiert sind, für die Kommunikation von Maschine zu Maschine, nämlich von tragbarem elektronischem Gerät zum Feldgerät, genutzt. Dies erspart die Realisierung einer zusätzlichen Kommunikationsschnittstelle am Feldgerät. Die neue Vorrichtung zur Übertragung von Daten ermöglicht eine deutlich höhere Eingabegeschwindigkeit als bei einer direkten Eingabe der Daten in das Feldgerät durch einen Bediener. Somit können dem Anwender weitere, bisher nicht über eine direkte Bedienung des Feldgeräts zugängliche Funktionen bereitgestellt werden. Beispielsweise ist es nun möglich, dass ein Anwender alle in einer EDD (Elektronic Device Description) gebotenen Funktionen bei einer Vor-Ort-Bedienung nutzt.

Insbesondere bei Feldgeräten, die für einen Einsatz in explosionsgefährdeten Bereichen ausgelegt sind, ist die neue Vorrichtung zur Übertragung von Daten mit Vorteil anwendbar, da zur Herstellung der Kommunikationsverbindung keinerlei Gehäusedeckel und ähnliches am Feldgerät geöffnet werden muss. Zudem sind keine störungsanfälligen elektrischen Kontakte und keine zusätzliche Funkstrecke zur Realisierung der Vorrichtung notwendig.

Die Vorrichtung zur maschinellen Betätigung der Eingabetastatur des Feldgeräts zeichnet sich durch einen besonders einfachen Aufbau aus, wenn der zweite Code durch die Tastsequenz einer Bedientaste bestimmt ist. Bei dieser Ausgestaltung wird genau eine Taste des Feldgeräts maschinell bedient. Beispielsweise durch einen variablen zeitlichen Abstand zwischen den Tastenbetätigungen oder durch die Betätigungsdauer können die zu übertragenden Daten in der Tastsequenz codiert werden. Damit das Feldgerät den eingegebenen Code auswertet, das heißt die Tastsequenz zum Empfang der übermittelten Daten decodiert, wird es zuvor durch eine geeignete Maßnahme in einen Zustand versetzt, in welchem seine Eingabetastatur für eine Kommunikation von Maschine zu Maschine aktiviert ist. Dies kann durch direkte Eingabe eines Bedieners oder ebenfalls durch eine maschinelle Tastenbetätigung erfolgen.

Die maschinelle Betätigung einer einzigen Taste ist zwar mit einem besonders geringen konstruktiven Aufwand verbunden, lässt aber, abhängig von den Eigenschaften des Tasters, nur eine doch beschränkte Datenrate zu. Sind mehrere Tasten der Eingabetastatur des Feldgeräts zur maschinellen Betätigung verfügbar, ist durch die Verwendung einer aufwendigeren Betätigungsvorrichtung eine parallele Nutzung mehrerer Tasten möglich und somit eine deutlich höhere Datenrate erzielbar. Der zweite Code, der den zum Feldgerät hin zu übertragenden Daten entspricht, wird in diesem Fall durch die Tastsequenz mehrerer, gleichzeitig betätigbarer Bedientasten bestimmt.

Die beschriebene Codierung mit Hilfe der Tastsequenz ist sowohl bei mechanischen Drucktasten als auch bei optisch oder elektrisch arbeitenden Berührungstasten oder einem so genannten Touch-Display, bei dem durch Berührung von Teilen der Anzeige Eingaben vorgenommen werden können, möglich.

Wenn die Anzeige und die Eingabetastatur des Feldgeräts durch einen derartigen berührungsempfindlichen Bildschirm realisiert sind, kann in vorteilhafter Weise ein Code zur Übertragung von Daten zu dem Feldgerät verwendet werden, der durch eine mit Hilfe der Betätigungsvorrichtung erzeugte Zeichenfolge bestimmt ist. Deutlich höhere Datenraten sind wiederum möglich, wenn die Betätigungsvorrichtung komplexe Zeichen auf den berührungsempfindlichen Bildschirm zeichnet, die durch eine geeignete Auswertesoftware im Feldgerät erkannt und in den entsprechenden Datenstrom umgewandelt werden können. Bei einer für Multi-Touch geeigneten Betätigungsvorrichtung können mehrere gleichzeitige Berührungen des Bildschirms für eine weitere Erhöhung der Codevarianten und damit für eine weitere Steigerung der Datenrate genutzt werden.

In einem sehr einfach zu realisierenden Ausführungsbeispiel der Erfindung kann der erste Code, der den vom Feldgerät zum elektronischen Gerät hin zu übertragenden Daten entspricht, durch die Hell-Dunkel-Sequenz einer Anzeigenbeleuchtung bestimmt sein. Diese Ausführung ist schon bei sehr einfachen Anzeigen anwendbar. Beispielsweise mit einer Anzeigenbeleuchtung auf LED-Basis sind bereits hohe Datenübertragungsraten realisierbar. In der Leseeinrichtung genügt zudem bereits ein einfacher Photodetektor zum Empfang des Lichtsignals.

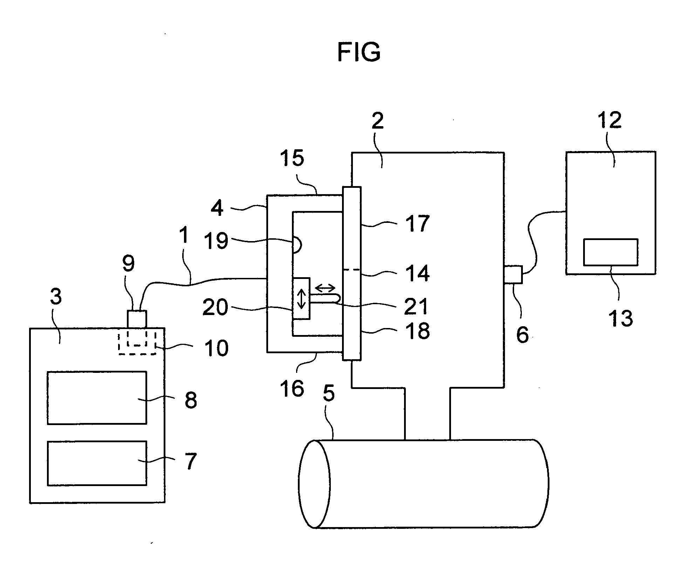

Eine weitere Möglichkeit stellt eine Codierung der zu übertragenden Daten durch ein auf der Anzeige wiedergegebenes komplexes Muster dar. Dazu können beispielsweise ein eindimensionaler Barcode oder ein zweidimensionaler Matrixcode verwendet werden. Eine Leseeinrichtung für derartige Codes kann beispielsweise durch eine Kamera mit einer geeigneten Bildauswertesoftware implementiert sein. Bei einfachen Mustern kann sowohl auf eine sehr einfache Kamera als auch auf eine sehr einfache Auswertesoftware zurückgegriffen werden, wie sie in Mobiltelefonen bereits häufig integriert sind. Anhand der Zeichnung, in der ein Ausführungsbeispiel der Erfindung dargestellt ist, werden im Folgenden die Erfindung sowie Ausgestaltungen und Vorteile näher erläutert.

Die einzige Figur zeigt ein tragbares elektronisches Gerät und ein Feldgerät mit einer Vorrichtung zur Übertragung von Daten.

In dem dargestellten Ausführungsbeispiel sind ein tragbares Bediengerät 3 und ein Feldgerät 2 zur Übertragung von Daten miteinander verbunden. Das Feldgerät 2 ist beispielsweise ein Druckmessumformer, der an eine Rohrleitung 5 einer nicht weiter dargestellten prozesstechnischen Anlage angebaut ist. Mit einem Netzwerkanschluss 6 ist das Feldgerät 2 an ein Netzwerk angeschlossen, über welches es mit einer übergeordneten Leitstation 12 kommuniziert, beispielsweise die Druckmesswerte an die Leitstation meldet, und über welches dem Feldgerät 2 die zu seinem Betrieb in der prozesstechnischen Anlage erforderliche Energie von einer Betriebsstromversorgung 13 in der Leitstation 12 zugeführt wird. Über den Netzwerkanschluss 6 ist das Feldgerät 2 fernbedienbar. Damit auch eine Vor-Ort-Bedienung möglich ist, verfügt das Feldgerät 2 über ein Touch-Display 14, das eine direkte Eingabe von Daten durch einen Bediener ermöglicht. Eine Parametrierung des Feldgeräts 2 über dieses Touch-Display 14 ist jedoch vergleichsweise aufwendig. Damit die Bedienung komfortabler gestaltet werden kann, ist das Feldgerät 2 mit dem tragbaren elektronischen Gerät 3 verbunden, das eine umfangreichere Tastatur 7 sowie eine Anzeige 8 aufweist, über welche ein Bediener Eingaben durchführen und Ausgaben des Feldgeräts 2 entgegennehmen kann. Ebenso kann in dem Gerät 3 ein Parametrierzyklus vorprogrammiert sein, mit dessen Hilfe die Parametrierung des Feldgeräts 2 auf vorbestimmte Weise automatisch durchgeführt wird. Die dazu erforderliche Vorrichtung zur Übertragung von Daten zwischen dem Bediengerät 3 und dem Feldgerät 2 weist ein Kabel 1 auf, das an seinem einen Ende mit einem Stecker 9 in eine dazu korrespondierende Buchse 10 des Bediengeräts 3 eingesteckt ist. Im Bediengerät 3 ist eine zum Betrieb der Schnittstelle geeignete Schaltung mit entsprechender Treibersoftware vorgesehen. Das Kabel 1 ist an seinem anderen Ende mit einem Koppelstück 4 versehen, das mit zwei Abstandhaltern 15 und 16, die an ihren Enden mit jeweils einem Saugnapf ausgestattet sein können, auf das Touch-Display 14 des Feldgeräts 2 aufgesetzt ist. Bei Verwendung von Saugnäpfen wird das Koppelstück 4 durch deren Haftkraft auf dem Display selbsttätig gehalten. In vorteilhafter Weise hat der Bediener damit die Hände für die Bedienung des tragbaren elektronischen Geräts frei. Zur Realisierung der Vorrichtung zur Übertragung von Daten ist in das Feldgerät 2 eine spezielle Treibersoftware geladen, bei deren Aktivierung das Display 14 in eine obere Hälfte 17 und eine untere Hälfte 18 unterteilt ist. Daten werden vom Feldgerät 2 zum Bediengerät 3 hin übertragen, indem auf der oberen Hälfte 17 des Displays 14 ein den zu übertragenden Daten entsprechender erster Code angezeigt wird, der mit Hilfe einer Leseeinrichtung 19, die als Kamera ausgeführt ist, optisch erfasst wird. Mit Hilfe einer in das Bediengerät 3 geladenen Software wird der erste Code decodiert, so dass die übermittelten Daten zurück gewonnen werden. In der Gegenrichtung, das heißt vom Bediengerät 3 zum Feldgerät 2, werden Daten mit Hilfe einer automatischen Betätigungsvorrichtung 20 übertragen. Diese weist einen in allen Richtungen beweglichen Stift 21 auf, der einen zweiten Code, der den zum Feldgerät 2 hin zu übertragenden Daten entspricht, auf die untere Hälfte 18 des Touch-Displays 14 zeichnet. Die in das Feldgerät 2 geladene, spezielle Treibersoftware wertet den zweiten Code zum Empfang der Daten aus. Auf die beschriebene Weise ist eine Vollduplex-Kommunikation zwischen Feldgerät 2 und Bediengerät 3 möglich, so dass das Feldgerät 2 auch in Fällen, in denen sein Touch-Display 14 für eine direkte Bedienung schlecht zugänglich ist, schnell und komfortabel durch das tragbare Bediengerät 3 parametrierbar oder diagnostizierbar ist.

Selbstverständlich weist das Feldgerät 2 einen Mikroprozessor zur Abarbeitung der erforderlichen Programme sowie einen Speicher auf, in welchen die Parameter hinterlegt werden.

Diese sind der Übersichtlichkeit wegen in der Figur nicht dargestellt.

## Patentansprüche

1. Vorrichtung bestehend aus einem tragbaren elektronischen Gerät und einem Feldgerät zur Übertragung von Daten zwischen dem tragbaren elektronischen Gerät (3) und dem Feldgerät (2), das eine Anzeige (17) und eine Eingabetastatur (18) aufweist, wobei das Feldgerät (2) dazu ausgebildet ist, auf der Anzeige (17) einen ersten maschinenlesbaren Code, der den zum elektronischen Gerät (3) hin zu übertragenden Daten entspricht, auszugeben, und wobei das elektronische Gerät (3) mit einer Leseeinrichtung (19) für den ersten Code versehen ist, **dadurch gekennzeichnet, dass** das elektronische Gerät (3) mit einer automatischen Betätigungsvorrichtung (20) zur Eingabe eines zweiten Codes über die Eingabetastatur (18) des Feldgeräts (2) versehen ist, der den zum Feldgerät (2) hin zu übertragenden Daten entspricht, und dass das Feldgerät (2) dazu ausgebildet ist, den zweiten Code auszuwerten.

2. Vorrichtung nach Anspruch 1, **dadurch gekennzeichnet, dass** der zweite Code durch die Tastsequenz einer Bedientaste bestimmt ist.

3. Vorrichtung nach Anspruch 1, **dadurch gekennzeichnet, dass** der zweite Code durch die Tastsequenz mehrerer, gleichzeitig betätigbarer Bedientasten bestimmt ist.

4. Vorrichtung nach Anspruch 1, **dadurch gekennzeichnet, dass** die Anzeige (17) und die Eingabetastatur (18) durch einen berührungsempfindlichen Bildschirm (14) realisiert sind und dass der zweite Code durch die mit Hilfe der Betätigungsvorrichtung (20) erzeugte Zeichenfolge bestimmt ist.

5. Vorrichtung nach einem der vorhergehenden Ansprüche, **dadurch gekennzeichnet, dass** der erste Code durch die Hell-Dunkel-Sequenz einer Anzeigenbeleuchtung bestimmt ist.

6. Vorrichtung nach einem der vorhergehenden Ansprüche, **dadurch gekennzeichnet, dass** der erste Code durch ein auf der Anzeige (17) dargestelltes Muster bestimmt ist.

7. Tragbares elektronisches Gerät für eine Vorrichtung bestehend aus dem tragbaren elektronischen Gerätund einem Feldgerät zur Übertragung von Daten zwischen dem tragbaren elektronischen Gerät (3) und dem Feldgerät (2), das eine Anzeige (17) und eine Eingabetastatur (18) aufweist, wobei das Feldgerät (2) dazu ausgebildet ist, auf der Anzeige (17) einen ersten maschinenlesbaren Code, der den zum elektronischen Gerät (3) hin zu übertragenden Daten entspricht, auszugeben, und wobei das elektronische Gerät (3) mit einer Leseeinrichtung (19) für den ersten Code versehen ist, **dadurch gekennzeichnet, dass** das elektronische Gerät (3) mit einer automatischen Betätigungsvorrichtung (20) zur Eingabe eines zweiten Codes über die Eingabetastatur (18) des Feldgeräts (2) versehen ist, der den zum Feldgerät (2) hin zu übertragenden Daten entspricht und durch das Feldgerät (2) auswertbar ist.

8. Feldgerät für eine Vorrichtung bestehend aus dem Feldgerät und einem tragbaren elektronischen Gerät zur Übertragung von Daten zwischen dem tragbaren elektronischen Gerät (3) und dem Feldgerät (2), das eine Anzeige (17) und eine Eingabetastatur (18) aufweist, wobei das Feldgerät (2) dazu ausgebildet ist, auf der Anzeige (17) einen ersten maschinenlesbaren Code, der den zum elektronischen Gerät (3) hin zu übertragenden Daten entspricht, auszugeben, und wobei das elektronische Gerät (3) mit einer Leseeinrichtung (19) für den ersten Code versehen ist, **dadurch gekennzeichnet, dass** das Feldgerät (2) dazu ausgebildet ist, einen zweiten Code auszuwerten, der durch das elektronische Gerät (3) mit einer automatischen Betätigungsvorrichtung (20) über die Eingabetastatur (18) des Feldgeräts (2) eingebbar ist und den zum Feldgerät (2) hin zu übertragenden Daten entspricht.

## Claims

1. Apparatus comprising a portable electronic appliance and a field device for transmitting data between the portable electronic appliance (3) and the field device (2), which has a display (17) and an input keypad (18), wherein the field device (2) is designed to use the display (17) to output a first machine-readable code which corresponds to the data that are to be transmitted to the electronic appliance (3), and wherein the electronic appliance (3) is provided with a reading device (19) for the first code, **characterized in that** the electronic appliance (3) is provided with an automatic operating apparatus (20) for inputting a second code using the input keypad (18) of the field device (2), which second code corresponds to the data that are to be transmitted to the field device (2), and **in that** the field device (2) is designed to evaluate the second code.

2. Apparatus according to Claim 1, **characterized in that** the second code is determined by the keying sequence of an operator control key.

3. Apparatus according to Claim 1, **characterized in that** the second code is determined by the keying sequence of a plurality of operator control keys that can be operated simultaneously.

4. Apparatus according to Claim 1, **characterized in that** the display (17) and the input keypad (18) are implemented by a touch-sensitive screen (14), and **in that** the second code is determined by the character string produced using the operating apparatus (20).

5. Apparatus according to one of the preceding claims, **characterized in that** the first code is determined by the bright/dark sequence of display lighting.

6. Apparatus according to one of the preceding claims, **characterized in that** the first code is determined by a pattern that is presented on the display (17).

7. Portable electronic appliance for an apparatus comprising the portable electronic appliance and a field device for transmitting data between the portable electronic appliance (3) and the field device (2), which has a display (17) and an input keypad (18), wherein the field device (2) is designed to use the display (17) to output a first machine-readable code which corresponds to the data that are to be transmitted to the electronic appliance (3), and wherein the electronic appliance (3) is provided with a reading device (19) for the first code, **characterized in that** the electronic appliance (3) is provided with an automatic operating apparatus (20) for inputting a second code using the input keypad (18) of the field device (2), which second code corresponds to the data that are to be transmitted to the field device (2) and is able to be evaluated by the field device (2).

8. Field device for an apparatus comprising the field device and a portable electronic appliance for transmitting data between the portable electronic appliance (3) and the field device (2), which has a display (17) and an input keypad (18), wherein the field device (2) is designed to use the display (17) to output a first machine-readable code which corresponds to the data that are to be transmitted to the electronic appliance (3), and wherein the electronic appliance (3) is provided with a reading device (19) for the first code, **characterized in that** the field device (2) is designed to evaluate a second code which can be input by the electronic appliance (3) with an automatic operating apparatus (20) using the input keypad (18) of the field device (2) and corresponds to the data that are to be transmitted to the field device (2).

## Revendications

1. Dispositif constitué d'un appareil électronique portatif et d'un appareil de terrain et destiné à la transmission de données entre l'appareil (3) électronique portatif et l'appareil ( 2 ) de terrain, qui a un affichage ( 17 ) et un clavier ( 18 ) d'entrée, l'appareil ( 2 ) de terrain étant constitué pour émettre sur l'affichage ( 17 ) un premier code pouvant être exécuté par une machine et correspondant aux données à transmettre à l'appareil ( 3 ) électronique, et l'appareil ( 3 ) électronique étant pourvu d'un dispositif ( 19 ) de lecture du premier code, **caractérisé en ce que** l'appareil ( 3 ) électronique est pourvu d'un dispositif ( 20 ) automatique d'actionnement pour l'entrée d'un deuxième code par l'intermédiaire du clavier ( 18 ) d'entrée de l'appareil ( 2 ) de terrain, deuxième code qui correspond aux données à transmettre à l'appareil ( 2 ) de terrain, et **en ce que** l'appareil ( 2 ) de terrain est constitué pour exploiter le deuxième code.

2. Dispositif suivant la revendication 1, **caractérisé en ce que** le deuxième code est déterminé par la séquence de manipulation d'une touche de service.

3. Dispositif suivant la revendication 1, **caractérisé en ce que** le deuxième code est déterminé par la séquence de manipulation de plusieurs touches de service pouvant être actionnées simultanément.

4. Dispositif suivant la revendication 1, **caractérisé en ce que** l'affichage ( 17 ) et le clavier ( 18 ) d'entrée sont réalisés par un écran ( 14 ) tactile et **en ce que** le deuxième code est déterminé par la suite de signes produite à l'aide du dispositif ( 20 ) d'actionnement.

5. Dispositif suivant l'une des revendications précédentes, **caractérisé en ce que** le premier code est déterminé par la séquence clair-obscur d'un éclairage d'affichage.

6. Dispositif suivant l'une des revendications précédentes, **caractérisé en ce que** le premier code est déterminé par un motif représenté sur l'affichage ( 17 ).

7. Appareil électronique portatif pour un dispositif constitué d'un appareil électronique portatif et d'un appareil de terrain et destiné à la production de données entre l'appareil ( 3 ) électronique portatif et l'appareil ( 2 ) de terrain, qui a un affichage ( 17 ) et un clavier ( 18 ) d'entrée, l'appareil ( 2 ) de terrain étant constitué pour émettre sur l'affichage ( 17 ) un premier code, qui peut être exploité par une machine et qui correspond aux données à transmettre à l'appareil ( 3 ) électronique, et dans lequel l'appareil ( 3 ) électronique est pourvu d'un dispositif ( 19 ) de lecture du premier code, **caractérisé en ce que** l'appareil ( 3 ) électronique est pourvu d'un dispositif ( 20 ) automatique d'actionnement pour l'entrée d'un deuxième code par le clavier ( 18 ) d'entrée de l'appareil ( 2 ) de terrain, deuxième code qui correspond aux données à transmettre à l'appareil ( 2 ) de terrain et qui peut être exploité par l'appareil ( 2 ) de terrain.

8. Appareil de terrain pour un dispositif constitué de l'appareil de terrain et d'un appareil électronique portatif et destiné à la transmission de données entre l'appareil ( 3 ) électronique et l'appareil ( 2 ) de terrain, qui a un affichage ( 17 ) et un clavier ( 18 ) d'entrée, l'appareil ( 2 ) de terrain étant constitué pour émettre sur l'affichage ( 17 ) un premier code, qui peut être exploité par une machine et qui correspond à des données à transmettre à l'appareil ( 3 ) électronique, et dans lequel l'appareil ( 3 ) électronique est pourvu d'un dispositif ( 19 ) de lecture du premier code, **caractérisé en ce que** l'appareil ( 2 ) de terrain est constitué pour exploiter un deuxième code, qui peut entré par l'appareil ( 3 ) électronique avec un dispositif ( 20 ) automatique d'actionnement par le clavier ( 18 ) d'entrée de l'appareil ( 2 ) de terrain, qui correspond aux données à transmettre à l'appareil ( 2 ) de terrain.
